# EUROPEAN PATENT APPLICATION

(11) **EP 0 569 762 A1**
(43) Date of publication of application: **18.11.1993**
(21) Application number: 93106718.5
(22) Date of filing: 26.04.1993
(51) Int. Cl.: G03F 1/00, G03F 7/004, G03F 7/095

(54) **Pattern formation in photohardenable dielectric layers**

(30) Priority: 07.05.1992 US 880091
(71) Applicant: E.I. DU PONT DE NEMOURS AND COMPANY, Wilmington Delaware 19898 (US)
(72) Inventor: Nebe, William John, Wilmington, Delaware 19808 (US)
(74) Representative: von Kreisler, Alek, Dipl.-Chem.

(57) **Abstract**

A method for forming a dielectric layer in a pattern, comprising the steps:
(a) applying to a substrate an unpatterned photohardenable first layer comprising (1) finely divided particles of non-glassy solids and (2) finely divided particles of an inorganic binder having a softening point temperature in the range from 550 to 825C dispersed in a matrix of (3) an organic polymeric binder, (4) a photoinitiating system, (5) a monomer and (6) an organic solvent;
(b) applying to the photohardenable first layer a second patterning layer comprising an agent which prevents the transmission of actinic radiation;
(c) exposing the photohardenable first layer to actinic radiation to effect photohardening of the photohardenable first layer in those areas not covered by the second patterning layer;
(d) removing the second patterning layer and the underlying non-photohardened areas of the first layer; and
(e) heating the substrate and the remaining photohardened areas of the first layer from step (d) to a temperature sufficient to effect volatilization of the organic binder, the photoinitiating system, the monomer and the organic solvent, and to effect sintering of the dielectric solids and inorganic binder.

## Description

### FIELD OF THE INVENTION

This invention is directed to a method for making patterns in dielectric layers. More particularly, it relates to a method for making patterns in photohardenable dielectric layers using nonphotosensitive patterning to form an integral mask.

### BACKGROUND OF THE INVENTION

Multilayer thick film circuits have been used for many years to increase circuit functionality per unit of area. Moreover, recent advances in circuit technology have placed new demands on dielectric materials for this use. Heretofore, most of the dielectric materials used in multiple circuits have been conventional thick film dielectric compositions. These are comprised of finely divided particles of dielectric solids and inorganic binders dispersed in an inert organic medium. The thick film materials are applied to a substrate in a pattern corresponding to the desired dielectric pattern, including holes for via formation. This is usually accomplished by screen printing onto a substrate in the desired pattern. The material is then heated, i.e., "fired", to volatize all the organic materials and sinter the inorganic materials.

An alternative approach is to use photosensitive, particularly photohardenable, dielectric materials. The dielectric is applied to the substrate with an inorganic binder as a dispersion in a photohardenable medium comprising a monomer, a binder and a photoinitiator. The dielectric layer is exposed to actinic radiation in an imagewise pattern, i.e., through a phototool, developed to remove the unexposed areas and fired.

A third approach is diffusion patterning, as has been disclosed by Felten in U.S. Patent 5,032,216. In this method, a first layer of nonphotosensitive dielectric material is applied to the substrate in an unpatterned manner, followed by a second patterned layer. The second, patterned layer diffuses down to the first layer effecting a change in the dispersibility of that layer. The first layer is then removed in those areas which have greater dispersibility.

Each of the above methods suffers from some disadvantages. Conventional screen printing in a pattern has limited resolution. Typically, it is difficult to obtain better than 8 mil (200 micrometer) line and space resolution and 8-10 mil (200-250 micrometer) diameter vias. Photosensitive dielectric materials require the use of phototools. There are problems getting adequate contact between the photosensitive layer and the phototool without having the phototool scratch the surface of the photosensitive layer. In addition, most photoinitiators which are used in photosensitive dielectric compositions are sensitive to room light. Thus these materials must be handled in a yellow light environment to prevent reactions initiated by room light. In diffusion patterning, the diffusing material has a tendency to spread in the X-Y direction as it diffuses vertically, leading to a loss in resolution.

It therefore would be desirable to have a process for making patterns in dielectric materials which overcomes many, if not all, of the above described disadvantages.

### SUMMARY OF THE INVENTION

This invention relates to a method for forming a patterned dielectric layer, comprising the steps:
(a) applying to a substrate an unpatterned photohardenable first layer comprising (1) finely divided particles of non-glassy dielectric solids and (2) finely divided particles of an inorganic binder having a softening point in the range from 550 to 825C dispersed in a matrix of (3) an organic polymeric binder, (4) a photoinitiating system, (5) a monomer, and (6) an organic medium;
(b) applying to the photohardenable first layer a second patterning layer comprising an agent which prevents the transmission of actinic radiation;
(c) exposing the photohardenable first layer to actinic radiation without the use of a phototool to effect photohardening of the photohardenable first layer in those areas not covered by the second patterning layer;
(d) removing the second patterning layer and the underlying non-photohardened areas of the first layer; and
(e) heating the substrate and the remaining photohardened areas of the first layer from step (d) to a temperature sufficient to effect volatilization of the organic binder, the photoinitiating system, the monomer and the organic solvent, and to effect sintering of the dielectric solids and inorganic binder.

### Definitions

As used herein, the following terms have the meanings indicated below.

The term "dispersible" means, with respect to a layer or film of given material, that the material is capable of being displaced or removed by physical or chemical action of a wash liquid. The term "developer" means a wash liquid in which a given material is dispersible. The term "photohardenable" means material which when exposed to actinic radiation becomes less dispersible in a given developer.

### DETAILED DESCRIPTION OF THE INVENTION

The invention relates to a process for forming dielectric layers in patterns. It is particularly suited for making dielectric layers with very small vias for electronic applications. In the process of the invention a first layer of a photohardenable dielectric material is applied to a substrate. To this is applied a patterning layer of nonphotosensitive material which prevents the transmission of actinic radiation. The composite is then exposed overall to actinic radiation causing photohardening of the first layer in those areas not covered by the second patterned layer. This is followed by a development step in which the second layer and the non-photohardened areas of the first layer are removed, leaving a patterned dielectric layer on the substrate. The dielectric layer can then be fired to volatile the organic materials and sinter the inorganic materials.

Photosensitive dielectric materials are conventionally exposed to actinic radiation through a phototool, i.e., a film having a pattern of opaque areas to prevent the transmission of radiation and clear areas which transmit radiation. However, most phototool materials, e.g., polyester, absorb substantial amounts of radiation below 350 nm even in the "clear" areas. Thus, the initiator systems which can be used are limited to those which absorb above 350 nm. The process of the invention has additional flexibility because the "phototool" is applied directly to the surface of the photohardenable layer. The areas to be imaged are open, not covered by "clear" material. Thus no radiation is screened and it is possible to use both conventional initiator systems and those sensitive to shorter UV wavelengths. In the latter case, there is the additional advantage that the photohardenable material is white light stable. Thus it can be prepared and handled in later processing steps without the need for yellow light conditions. The activating short wavelengths are not emitted by most white light incandescent and fluorescent bulbs.

### I. Process Steps

The first step in the process of the invention is the application of a layer of photosensitive dielectric material onto a substrate. The photosensitive material can be applied in the form of either a film or a thick film paste. Film materials generally have a thickness in the range of about 1 mil (0.0025 cm) to 10 mils (0.025 cm) and are applied by lamination. Thick film materials are generally applied by screen printing in the same thickness range. Alter printing, the thick films are dried at slightly elevated temperatures, typically 50-100C.

The next step in the process of the invention is the application of a second patterning layer of nonphotosensitive material over the photohardenable layer. The patterning layer can be applied by a number of different techniques. The exact choice of application method will depend on the nature and properties of the material in the patterned layer. Some application techniques which can be used include screen printing; writing with an ink jet printhead similar to those found in commercially available computer printers; printing with solid state toners, e.g., by a laser printer; thermal transfer printing; direct writing with a pen on a plotter; and printing with flexographic, gravure or offset printing systems. Many of these application methods can use digitized information so that the design and any alterations of the pattern can be generated by computer. This "digital imaging" technique can be very advantageous with greater speed, flexibility and accuracy.

The second patterning layer is generally dried before the next step in the process, i.e., before the exposure step. Drying of this layer is carried out in the same way as for the photohardenable layer. In some cases it is not necessary to dry the second patterning layer.

The thickness of the second patterning layer depends on the method of application and the effective opacity of the material. If too little material is applied it will not be effective as a mask, i.e., it will not prevent actinic radiation from exposing the photohardenable layer underneath the mask. If the patterned layer is too thick it may be difficult to obtain the necessary resolution. When the patterning material is applied by screen printing or printing plate systems, the layer will usually be at least 0.5 mil (0.0013 cm) thick and generally is 1 to 2 mils (0.0025 to 0.050 cm) thick. When the patterned layer is applied by laser printing, thermal transfer or ink jet printer, the layer may be thinner, provided that it has sufficient opacity. It is preferred that the patterning layer provide an optical density of at least 3 as measured by a reflection densitometer.

The next step in the process of the invention is to expose the assembly of substrate, first photohardenable layer and second patterning layer to actinic radiation. The second patterning layer acts as a mask so that only those areas of the first photohardenable layer which are not covered by the patterning material will be exposed to radiation resulting in polymerization. Because the second patterning layer is printed directly on the surface of the photohardenable layer there are no problems associated with gaps between the phototool and the photohardenable layer. Moreover, there is no potential to scratch the surface of the photohardenable layer, as when using a separate phototool. Any radiation source emitting radiation having the proper wavelength and adequate intensity can be used. Some suitable sources include mercury and mercury-xenon, carbon arc lamps, and other conventional UV sources.

The next step in the process of the invention is the development of the first layer and removal of the second patterning layer. The first layer is removed in those areas which have not photohardened, i.e., those areas which were not exposed to actinic radiation and thus are more dispersible in a developer. The development step can be carried out using any conventional development technique including spraying the developer on the exposed assembly and immersing the assembly, with or without agitation. The second patterning layer should be completely and quickly removed by the developer in order to achieve good development of the underlying photohardenable layer.

Alter the development step the assembly consists of the substrate and the photohardened areas of the first layer. This then can be fired as an individual layer, or additional conductive and dielectric layers can be added to the first layer and the multilayer assembly fired together (cofired).

The heating cycle must be such that first the organic materials are volatilized and then the inorganic materials are sintered. The firing step is usually a two to three hour cycle. The first stage in the firing process is carried out at a temperature below the softening point temperature of the inorganic binder, typically below 500C. It is during this stage that the organic materials are volatilized. The second stage in the firing process is carried out at a temperature above the softening point of the inorganic binder, typically 800-1000C. It is during this stage that the inorganic binder softens and sinters with the dielectric solids. When the first layer is fired as an individual layer, it is preferred that firing take place in an air atmosphere to insure complete oxidation and volatilization of the organic materials.

If the first layer is cofired with other layers, the firing conditions will depend on the nature of the other materials present, particularly the conductor materials. When gold or silver conductor materials are used, the multilayer assembly can be fired in air at the temperatures described above, as long as the temperature does not exceed the melting point of the conductor metal. When copper conductor materials are present, an air atmosphere cannot usually be used for firing because of the undesirable oxidation of copper to copper oxides. In this case, the assembly is first fired in a substantially nonoxidizing atmosphere to volatile the organic materials and then fired in an essentially nonoxidizing atmosphere for the sintering phase. The term "substantially nonoxidizing" means an atmosphere which contains insufficient oxygen to effect any significant oxidation of copper metal but which nevertheless contains sufficient oxygen to effect oxidation and volatilization of the organic materials. In practice it has been found that a nitrogen atmosphere of 100-1000 ppm oxygen is appropriate in the presintering phase of the firing step. From 300 to 800 ppm oxygen is preferred. The term "essentially nonoxidizing" means an inert atmosphere containing only residual amounts of oxygen. In practice it has been found that a nitrogen atmosphere having 100 ppm oxygen or less is appropriate for the sintering phase of the firing step.

### II. Materials

### A. Substrate

The method of the invention can be used on inorganic substrates which are typically used with thick film processes. Examples of suitable substrates include Al₂O₃, SiO₂, silicon, AlN and the like.

### B. Photohardenable Dielectric Layer

The photohardenable dielectric layer comprises (1) finely divided particles of nonglassy dielectric solids and (2) finely divided particles of an inorganic binder having a softening point in the range from 550 to 825C, which is dispersed in a matrix of (3) an organic polymeric binder, (4) a photoinitiating system which is sensitive to actinic radiation, (5) a monomer, and (6) an organic solvent.

### 1. Dielectric Solids

The invention is applicable to virtually any high melting inorganic solid material. However, it is particularly suitable for making dispersions of dielectric solids such as alumina, titanates, zirconates and stannates. It is also applicable to precursors of such materials, i.e., solid materials which upon firing are converted to dielectric solids, and to mixtures of any of these.

Among the many dielectric solids which are likely to be used in the invention are BaTiO₃, CaTiO₃, SrTiO₃, PbTiO₃, CaZrO₃, BaZrO₃, CaSnO₃, BaSnO₃, and Al₂O₃. As will be apparent to those skilled in the ceramic arts, the exact chemical composition of the dielectric solids to be used in the composition of the invention is not ordinarily critical in the rheological sense. It is also preferred that the dielectric solids not have swelling characteristics in the organic material in which it is dispersed, since the rheological properties of the dispersion may be substantially changed thereby.

It has been found that the dispersion of the dielectric solids should contain no significant amount of solids having a particle see of less than 0.2 micrometer in order to obtain adequately complete volatilization of the organic materials when the films or layers thereof are fired to remove the organic materials and to effect sintering of the inorganic binder and the dielectric solids. However, none of the dielectric solids ordinarily will exceed 20 micrometers and, furthermore, it is preferred that at least 80 wt. % of the dielectric solids must have a size of 1-10 micrometers. When the dispersions are used to make thick film pastes, which are usually applied by screen printing, the maximum particle size should not exceed the thickness of the screen, and when the dispersion is used to make dry photohardenable film, the maximum particle size must not exceed the thickness of the film.

In addition, it is preferred that surface area/weight ratio of the dielectric particles not exceed 10 m²/g for the reason that such particles tend to affect adversely the sintering characteristics of the accompanying inorganic binder. It is still further preferred that the surface area/weight ratio not exceed 5 m²/g. Dielectric particles having a surface area/weight ratio of 1-5 have been found to be quite satisfactory.

A preferred particle size for d50, i.e., a point at which the number of smaller particles equals the number of larger particles, is in a range from 2.30-2.70 micrometers. This size range is preferred to achieve a blister free surface while maintaining a hermetic structure.

A preferred material is alumina. A preferred procedure is to pass the milled water alumina slurry through a fine mesh screen (e.g., 400 mesh) to remove large particles and also through a magnetic separator. The magnetic separator removes all magnetic conductive materials which otherwise would increase the conductivity of the final product. The alumina can also be freeze dried after milling.

### 2. Inorganic Binder

The inorganic binder, i.e., glass frit, used in the present invention aids in sintering the inorganic crystalline particulates and may be of any well known composition which has a melting temperature below that of the dielectric solids. It is preferred that the softening point of the inorganic binder be 550 to 825C and still more preferably 575 to 750C. If melting takes place below 550C, organic material will likely be encapsulated and blisters will tend to form in the dielectric layer as the organics decompose. On the other hand, a softening point above 825C will tend to produce a porous dielectric when sintering temperatures compatible with copper metallizations, e.g., 900C, are used.

The glass frits most preferably used are the borosilicate frits, such as lead borosilicate frit, bismuth, cadmium, barium, calcium or other alkaline earth borosilicate frits. The preparation of such glass frits is well known and consists, for example, in melting together the constituents of the glass in the form of the oxides of the constituents and pouring such molten composition into water to form the frit. The starting materials may also be glass precursors, i.e., compounds that will yield the desired oxides under the usual conditions of frit production.

Thereafter the frit is preferably processed in a similar manner as the dielectric solids. The frit is passed through a fine mesh screen to remove large particles since the solid composition should be agglomerate free. The inorganic binder like the ceramic solids should have a surface to weight ratio of no more than 10 m²/g and at least 90 wt. % of the particles preferably have a particle size of 1-10 micrometers.

It is preferred that the d50 of the inorganic binder be equal to or less than that of the dielectric solids. For a given particle size dielectric solids, the inorganic binder/dielectric solids ratio required to achieve hermeticity will decrease as the inorganic binder size decreases. With a given dielectric solids-inorganic binder system, if the ratio of inorganic binder to ceramic solids is significantly higher than that required to achieve hermeticity, the dielectric layer tends to form blisters on firing. If the ratio is significantly lower, the fired dielectric will be porous and therefore nonhermetic.

Within the above-described particle size and surface area limits, it is nevertheless preferred that the inorganic binder particles be 0.5-6 micrometer. The reason for this is that smaller particles having a high surface area tend to absorb the organic materials and thus impede clean decomposition. On the other hand, larger size particles tend to have poorer sintering characteristics. It is preferred that the inorganic binder is present in an amount of 10 to 70% by weight based on the total solids weight.

### 3. Organic Binder

The organic binder is important in the processing of the photohardenable layer, i.e., the development step. Prior to exposure to actinic radiation and photohardening, the binder must be soluble, swellable or dispersible in the developer. The developer may be aqueous or semi-aqueous solutions or an organic solvent. Suitable nonaqueous-developable binders include: (1) homopolymers and copolymers of C₁₋₁₀ alkyl acrylates, C₁₋₁₀ alkyl methacrylates, alphamethylstyrene and 0-2 wt.% ethylenically unsaturated carboxylic acid, amine or silane-containing compounds;
(2) homopolymers and copolymers of C₁₋₁₀ mono-olefins;
(3) homopolymers and copolymers of C₁₋₄ alkylene oxide; and
(4) mixtures thereof. Suitable binders which can be developed with aqueous or semi-aqueous developers include those of type (1) above in which the carboxylic acid component is increased to 2-15% (semi-aqueous) or greater than 15% (aqueous).

The binder is generally present in an amount of 5-15% by weight, based on the total weight of the inorganic solids.

Suitable developers can be found in the well known photoresist art. For organic solvent development, 1,1,1-trichloroethane is frequently used. Suitable aqueous developers include 0.5-2 wt. % solutions of sodium carbonate or trisodium phosphate. Examples of semi-aqueous developers include solutions of 1 wt. % sodium carbonate and 3-5 vol. % butyl Carbitol; or 0.5-1 wt. % sodium borate and 5-10% butyl cellusolve.

### 4. Photoinitiation System

Suitable photoinitiation systems are those which are thermally inactive but which generate free radicals upon exposure to actinic radiation at or below 185C. In addition to conventional photoinitiation systems, the photoinitiation systems which can be used in the process of the invention include those which are sensitive to actinic radiation having a wavelength less than 350 nm. These photoinitiation systems will not initiate photohardening in room light. This makes it possible to handle and process the materials without having to use yellow-light conditions.

Examples of suitable photoinitiation systems include the substituted or unsubstituted polynuclear quinones which are compounds having two intracyclic carbon atoms in a conjugated carbocyclic ring system, e.g., 9, 10-anthraquinone, 2-methylanthraquinone, 2-ethylanthraquinone, 2-tertbutylanthraquinone, octamethylanthraquinone, 1,4-naphthoquinone, 9,10-phenanthrenequinone, benz(a)anthracene-7,12-dione, 2,3-naphthacene-5,12-dione, 2-methyl-1,4-naphthoquinone, 1,4-dimethylanthraquinone, 2,3-dimethylanthraquinone, 2-phenylanthraquinone, 2,3-diphenylanthraquinone, retenequinone, 7,8,9,10-tetrahydronaphthacene-5,12-dione, and 1,2,3,4-tetrahydrobenz(a)anthracene-7,12-dione. Other photoinitiators which are also useful are described in U.S. Pat. No. 2,760,863 and include xanthone and isopropylthioxanthone; 4-benzyl-4'-methyldiphenylsulfide; ethyl-4-dimethylamino-benzoate; 2,2-dimethoxy-2-phenylacetophenone; vicinal ketaldonyl alcohols such as benzoin, pivaloin, acyloin ethers, e.g., benzoin methyl and ethyl ethers; α-hydrocarbon-substituted aromatic acyloins, including α-methylbenzoin, α-allylbenzoin and α-phenylbenzoin. Photoreducible dyes and reducing agents disclosed in U.S. Pat. Nos. 2,850,445, 2,875,047, 3,097,096, 3,074,974, 3,097,097, and 3,145,104, as well as dyes of the phenazine, oxazine and quinone classes, Michler's ketone, benzophenone, 2,4,5-triphenylimidazolyl dimers with hydrogen donors including leuco dyes and mixtures thereof as described in U.S. Pat. Nos., 3,427,161, 3,479,185, and 3,549,367 can be used as initiators. Also useful with photoinitiators and photoinhibitors are sensitizers disclosed in U.S. Pat. No. 4,162,162.

The photoinitiator or photoinitiator system is present in the amount of 0.05 to 10% by weight based on the total weight of the dry photohardenable layer.

### 5. Monomer

The monomer component of the invention is comprised of at least one addition polymerizable ethylenically unsaturated compound having at least one polymerizable ethylenic group. Such compounds are capable of forming a high polymer by free radical initiated, chain propagating addition polymerization and/or of crosslinking with polymeric binders in which there are residual sites of unsaturation. The monomeric compounds are nongaseous, i.e., they have a normal boiling point above 100C and a plasticizing action on the organic polymeric binder.

Suitable monomers which can be used alone or in combinations with other monomers include t-butyl acrylate and methacrylate, 1,5-pentanediol diacrylate and dimethacrylate, N,N-diethylaminoethyl acrylate and methacrylate, ethylene glycol diacrylate and dimethacrylate, 1,4-butanediol diacrylate and dimethacrylate, diethylene glycol disacrylate and dimethacrylate, hexamethylene glycol diacrylate and dimethacrylate, 1,3-propanediol diacrylate and dimethacrylate, decamethylene glycol diacrylate and dimethacrylate, 1,4-cylcohexanediol diacrylate and dimethacrylate, 2,2-dimethylolpropane diacrylate and dimethacrylate, glycerol diacrylate and dimethacrylate, tripropylene glycol diacrylate and dimethacrylate, glycerol triacrylate and trimethacrylate, triacrylate and trimethylolpropane triacrylate and trimethacrylate, pentaerythritol triacrylate and trimethacrylate, polyoxyethylated trimethylolpropane triacrylate and trimethacrylate and similar compounds as disclosed in U.S. Pat. No. 3,380,831, 2,2-di(p-hydroxyphenyl)-propane diacrylate, pentaerythritol tetraacrylate and tetramethacrylate, 2,2-di-(p-hydroxyphenyl)-propane dimethacrylate, triethylene glycol diacrylate, polyoxethyl- 2,2-di-(p-hydroxyphenyl)propane di-methacrylate, di-(3-methacryloxy-2-hydroxypropyl)ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of 1,4-butanediol, triethylene glycol dimethacrylate, polyoxypropyltrimethylol propane triacrylate, butylene glycol diacrylate and dimethacrylate, 1,2,4-butanetriol triacrylate and trimethacrylate, 2,2,4-trimethyl-1,3-pentanediol diacrylate and dimethacrylate, 1-phenyl ethylene-1,2-dimethacrylate, diallyl fumarate, styrene, 1,4-benzenediol dimethacrylate, 1,4-diisopropenyl benzene, and 1,3,5-triisopropenyl benzene. Also useful are ethylenically unsaturated compounds having a molecular weight of at least 300, e.g., alkylene or a polyalkylene glycol diacrylate prepared from an alkylene glycol of 2 to 15 carbons or a polyalkylene ether glycol of 1 to 10 ether linkages, and those disclosed in U.S. Pat. No. 2,927,022, e.g., those having a plurality of addition polymerizable ethylenic linkages particularly when present as terminal linkages. Preferred monomers are polyoxyethylated trimethylolpropane triacrylate, ethylated pentaerythritol triacrylate, dipentaerythritol monohydroxypentaacrylate and 1,10-decanediol dimethylacrylate. Other preferred monomers are monohydroxypolycaprolactone monoacrylate, polyethyleneglycol diacrylate (mol. wt. approximately 200), and polyethylene glycol 400 dimethacrylate (mol. wt. approximately 400).

The unsaturated monomeric component is present in an amount of 5 to 45% by weight based on the total weight of the dry photohardenable layer.

### 6. Organic Solvent

The main purpose of the organic solvent is to serve as a vehicle for dispersion of the finely divided solids of the composition in such form that it can readily be applied to a ceramic or other substrate. Thus, the solvent must first be one in which the solids can form a dispersion with an adequate degree of stability. Secondly, the rheological properties of the organic solvent must be such that they lend good application properties to the dispersion.

The organic solvent, polymeric binder, monomer, initiator and other optional organic additives constitute the "organic medium" in which the inorganic materials are dispersed.

When the dispersion is to be made into a film, the solvent component of the organic medium, which may be a mixture of solvents, is chosen so as to obtain complete solution therein of the polymer and to be of sufficiently high volatility to enable the solvent to be evaporated from the dispersion by the application of relatively low levels of heat at atmospheric pressure. In addition, the solvent must boil well below the boiling point and decomposition temperature of any other additives contained in the organic medium. Examples of suitable solvents include benzene, acetone, xylene, methanol, ethanol, methylethyl ketone, 1,1,1-trichlorethane, tetrachlorethylene, amyl acetate, 2,2,4-triethyl pentanediol-1,3-monoisobutyrate, toluene, methylene chloride, and ethylene glycol monoalkyl and dialkyl ethers such as ethylene glycol mono-n-propyl ether. For casting films, methylene chloride is particularly preferred because of its volatility.

Frequently the organic medium will also contain one or more plasticizers which serve to lower the T_{g} of the binder polymer. Such plasticizers help to assure good lamination to ceramic substrates and enhance the developability of unexposed areas of the composition. However, the use of such materials should be minimized in order to reduce the amount of organic materials which must be removed when the films cast therefrom are fired. The choice of plasticizers is, of course, determined primarily by the polymer which must be modified. Among the plasticizers which have been used in various binder systems are diethyl phthalate, dibutyl phthalate, butyl benzyl phthalate, dibenzyl phthalate, alkyl phosphates, polyalkylene glycols, glycerol, poly(ethylene oxides), hydroxy ethylated alkyl phenol, tricresyl phosphate triethyleneglycol diacetate and polyester plasticizers. Dibutyl phthalate is frequently used with acrylic polymer systems because it can be used effectively in relatively small concentrations.

It is preferred that the weight ratio of the inorganic solids (dielectric plus glass) to organics be within the range of 0.5 to 8.0 for when the dispersion is made into a film; more preferably, from 1.0 to 6.0. The ratio of inorganic solids to organics is dependent on the particle size of the inorganic solids, the organic components and on surface pretreatment of the inorganic solids. When the particles are treated with organosilane coupling agents, the ratio of inorganic solids to organics can be increased.

On the other hand, when the dispersion is to be applied as a thick film paste, conventional thick film organic media can be used with appropriate rheological adjustments and the use of lower volatility solvents. The thick film compositions will usually be applied to the substrate by means of screen printing. Therefore, they must have appropriate viscosity so that they can be passed through the screen readily. While the rheological properties are of primary importance, the organic medium is preferably formulated also to give appropriate wettability of the solids and the substrate, good drying rate, dried film strength sufficient to withstand rough handling and good firing properties. Satisfactory appearance of the fired composition is also important.

The organic medium for most thick film compositions is typically a solution of resin in a solvent, in this case a solution of the polymeric binder, monomer and photoinitiator discussed above. The solvent usually is one which boils within the range of 130-250C. The most widely used solvents for thick film applications are terpenes such as alpha- or beta-terpineol or mixtures thereof with other solvents such as kerosene, dibutylphthalate, butyl Carbitol, butyl Carbitol acetate, hexamethylene glycol and high boiling alcohols and alcohol esters. Various combinations of these and other solvents are formulated to obtain the desired viscosity and volatility requirements for each application.

The organic medium can also contain a dispersant to insure the efficient wetting of the inorganic by the organic polymers and monomers. It is preferred that a dispersant be added when the dielectric is formulated as a thick film paste for screen printing. A thoroughly dispersed inorganic is desirable in the preparation of a photoactive paste with the needed characteristics of good screen printing and leveling and fire out characteristics. The dispersant acts to allow the polymeric binder to associate or wet the inorganic solids, giving an agglomerate free system. The dispersants of choice are the A-B dispersants generally described in "Use of A-B Block Polymers as Dispersants for Non-aqueous Coating Systems" by H. K. Jakubauskas, Journal of Coating Technology, Vol. 58; Number 736; Pages 71-82. Useful A-B dispersants are disclosed in U.S. Patents 3,684,771, 3,788,996, 4,070,388 and 4,032,698 and U.K. Patent 1,339,930.

The dispersant is generally present in an amount of 0.1-5.0 percent by weight based on the photohardenable composition.

The organic medium may include small amounts of other components, e.g., pigments, dyes, thermal polymerization inhibitors, adhesion promoters, such as organosilane coupling agents, plasticizers, coating aids such as polyethylene oxides, etc. so long as the photohardenable compositions retain their essential properties. Organosilanes are particularly useful in quantities of 3.0 wt. % or less based on the weight of the inorganic particles. Treated particles have a lower demand for organics. Thus, the level of organics in the coating can be reduced, which results in easier volatilization upon firing.

The ratio of organic medium to inorganic solids in the thick film dispersions can vary considerably and depends upon the manner in which the dispersion is to be applied and the kind of organic medium used. Normally, to achieve good coverage, the dispersions will contain complementally by weight 50-90% solids and 50-10% organic medium. Such dispersions are usually of semifluid consistency and are referred to commonly as "pastes".

### C. Second, Nonphotohardenable Layer

The second, nonphotohardenable patterning layer is applied over the photohardenable first layer. In general, the patterning layer comprises a radiation-opaque material, i.e., an agent which prevents the transmission of actinic radiation, dispersed in an organic medium. It frequently will further comprise additional inorganic solids to provide the necessary rheological properties.

### 1. Radiation-Opaque Material

Almost any material which is opaque to radiation at the wavelength(s) at which the photoinitiator is sensitive can be used here. It must have sufficient opacity, i.e., optical density, to prevent photohardening of the first layer in the area immediately beneath the patterned layer. The material also must not interact chemically with the photohardenable layer. The radiation-opaque material should be removed completely in the development step, i.e., it should be dispersible in the developer. The radiation-opaque material should also be removed quickly by the developer solvent to facilitate the development of the underlying photohardenable first layer. In general, materials which are suitable as the radiation-opaque material will be pigments, such as, e.g., carbon black, copper chromite, chromium oxides, cobalt chrome aluminate and other dark inorganic pigments. Preferred pigments are those containing carbon black. The radiation-opaque material will generally comprise from 10-40% by weight of the patterning layer.

### 2. Inorganic Solids

In general, the radiation-opaque material will be mixed with additional inorganic solids in the patterning layer in order to obtain the level of solids necessary for good application characteristics. When the patterning layer is applied by screen printing, it is preferred that additional inorganic solids be present in order to obtain the appropriate rheological properties. The inorganic solids should be essentially inert and should be dispersible in the organic medium. Suitable inorganic solids include the dielectric solids and inorganic binders discussed above. A preferred inorganic solid is alumina.

### 3. Organic Medium

The primary function of the organic medium is to facilitate the application of the radiation-opaque material to the first photohardenable layer in the desired pattern. Thus the medium must first be one in which the radiation-opaque material and any additional inorganic solids can be dispersed with an adequate degree of stability. Secondly, the rheological properties of the organic medium must be such that they lend good application properties to the dispersion.

The organic medium generally comprises an organic solvent or mixture of solvents. It should be of sufficiently high volatility to enable the solvent to be evaporated from the dispersion by the application of relatively low levels of heat at atmospheric pressure. In addition, the solvent must boil well below the boiling point and decomposition temperature of any other additives contained in the organic medium. Examples of suitable solvents include terpenes such as alpha- or betaterpineol or mixtures thereof with other solvents such as kerosene, dibutylphthalate, butyl Carbitol, butyl Carbitol acetate, hexamethylene glycol and high boiling alcohols and alcohol esters. Various combinations of these and other solvents are formulated to obtain the desired viscosity and volatility requirements for each application.

It is preferred that the organic medium for the patterning materials also comprise an organic polymer binder. Suitable binders include those discussed above. The organic medium can additionally comprise plasticizers, dispersants and other additives such as those described above for the photohardenable layer.

The ratio of organic medium to radiation-opaque material and inorganic solids can vary considerably and depends upon the manner in which the patterning layer is to be applied and the kind of organic medium used. Normally, to achieve good coverage, the dispersions will contain complementally by weight 40-90% solids and 60-10% organic medium.

### EXAMPLES

In the following examples all parts and percentages are by weight unless otherwise indicated.

### I. Materials

- AB-I:: A-B Dispersant
- Alumina I:: 98.23% alumina, 1.77% cobalt aluminate which has been passed through a magnetic separator and freeze dried; d50 of 2.3-2.7 micrometers
- Alumina II:: 100% alumina which has been passed through a magnetic separator and freeze dried; d50 of 2.3-2.7 micrometers
- Binder I:: Copolymer of 75% methylmethacrylate and 25% methacrylic acid; MW = 7000, Tg = 160C, Acid No. = 160
- Binder II:: Amphomer, National Starch Co. (Bridgewater, NJ)
- Ceramic I:: Calcium zirconate which has been passed through a magnetic separator and freeze dried; particle size = 2-6 micrometers
- Ceramic II:: cobalt chrome aluminate which has been passed through a magnetic separator and freeze dried particle size = 2-6 micrometers
- Frit I:: 35.37% SiO₂; 5.99% BiO; 18.00% CuO; 36.54% ZnO; 2.39% ZrO₂; 1.71% Al₂(PO₄)₃; d50 of 2.2-3.0 micrometers
- Frit II:: 40.2% SiO₂; 5.9% B₂O₃; 9.9% Al₂O₃; 8.0% PbO; 5.1% CaO; 8.0% ZnO; 5.0% MgO; 17.9% BaO; d50 of 2.2-3.0 micrometers
- Frit III:: 57.22% SiO₂; 4.51% B₂O₃; 8.85% Al₂O₃; 17.00% PbO; 7.55% CaO; 2.45% Na₂O; 1.60% K₂O; 0.82 MgO; d50 of 2.2-3.0 micrometers
- Initiator BMS:: 4-Benzyl-4'-methyldiphenyl sulfide; Quantacure BMS made by International Bio-synthetics, Ltd. (Cheshire, UK)
- Initiator BTC:: (4-Benzoylbenzyl) trimethylammonium chloride; Quantacure BTC, made by International Bio-synthetics, Ltd. (Cheshire, UK)
- Monomer I:: polyoxyethylated trimethylolpropane triacrylate; MW = 1162
- Monomer II:: trimethylolpropane triacrylate
- Pigment:: Drakenfield 1795 black pigment made by Ciba-Geigy (Hawthorn NH)
- Solvent:: Beta-terpineol
- Stabilizer:: 2,6-di-t-butyl-4-methylphenol

### II. Preparation of Photohardenable Dielectric Material

### A. Vehicle Mixtures

Mixtures of initiator, stabilizer, binder, plasticizer and solvent were prepared and are herein referred to as the "vehicle".

Solvent and organic polymeric binder were mixed and heated with stirring to 135C. Heating and stirring was continued until all the binder had dissolved. The solution was then cooled to 100C and the initiator and stabilizer added. This mixture was then stirred at 100C until the solids had dissolved.

### B. Paste Formulation

The dielectric paste was prepared by mixing the monomer and dispersant with the mixture from A above. The glass frit and dielectric solids were then added and mixing was continued for 30 minutes. This was then aged for approximately 12 hours and then roll milled using a three roll mill, at a roll pressure of 400 psi. The paste was then screened through a 400 mesh screen. The paste viscosity at this point was adjusted by the addition of beta-terpineol to 80-120 poise, which is optimum for screen printing.

### III. Preparation of Patterning Material

The patterning material was prepared by mixing the solvent and other organic materials (binder, dispersant, etc.) at room temperature. To this was added the inorganic binder and pigment. This was mixed using a roll mill.

### IV. Process Conditions

The dielectric paste was applied to an alumina ceramic substrate by screen printing using a 200 mesh screen to a wet thickness of 50 micrometers. This was dried at 75C in air for 15 minutes resulting in a 25 micrometer dry thickness. The printing and drying steps were repeated to produce a total thickness of 50 micrometers.

The patterning material was applied to the dried dielectric layer by screen printing using a 400 mesh patterned screen to a wet thickness of 20 micrometers. This was dried at 75C in air for 10 minutes resulting in a 10 micrometer dry thickness.

The assembly from above was then exposed using a mercury-xenon lamp with an intensity of 16 mwatts/cm² at a distance of about 18 cm for the amount of time shown below. The exposed parts were developed using a Du Pont ADS-24 Processor (E. I. du Pont de Nemours & Co., Wilmington, DE) containing 0.8% sodium carbonate in water as developer. Development was carried out at 85F (30C) for 30 seconds.

The developed parts were dried in a forced draft oven at 75C for 15 minutes and fired in air in a furnace with a peak temperature of 900C over a two-hour cycle.

In addition, unexposed parts were exposed to normal fluorescent room light for the times shown below and examined for signs of photohardening or fogging in the photohardenable layer.

### Examples 1-6

These examples illustrate the process of the invention using different photoinitiators in the photohardenable dielectric layer which absorb light at less than 350 nm.

The dielectric layer had the composition shown in Table 1 using the vehicle mixtures given in Table 2. The exposure times and results are summarized below in Table 5.

**Table 1**

| **Photosensitive Dielectric Composition** | |
|---|---|
| **Ingredient** | **Parts** |
| Frit I | 52.0 |
| Ceramic I | 2.70 |
| Ceramic II | 0.30 |
| Vehicle Mixture (Table 2) | 31.00 |
| Monomer I | 8.48 |
| Monomer II | 2.12 |
| AB-I | 2.10 |
| Solvent II | 3.00 |

**Table 2**

| **Vehicle Mixture** | | | | | | |
|---|---|---|---|---|---|---|
| **Ingredient** | **1** | **2** | **3** | **4** | **5** | **6** |
| Binder I | 40.0 | 40.0 | 40.0 | 40.0 | 40.0 | 40.0 |
| Solvent II | 58.7 | 57.7 | 58.7 | 57.7 | 58.7 | 57.7 |
| Stabilizer | 0.3 | 0.3 | 0.3 | 0.3 | 0.3 | 0.3 |
| Benzoin Methyl | 1.0 | - | - | - | - | - |
| Xanthone | - | 2.0 | 1.0 | 1.0 | - | - |
| Benzoin | - | - | - | 1,0 | - | - |
| Initiator BMS | - | - | - | - | 2.0 | - |
| Initiator BTC | - | - | - | - | - | 2.0 |

A patterning layer was prepared with the composition given in Table 3.

**Table 3**

| **Patterning Layer Composition** | |
|---|---|
| **Ingredient** | **Parts** |
| Pigment | 25.0 |
| Alumina I | 35.0 |
| Binder Mixture^{a} | 30.0 |
| Solvent | 6.0 |
| AB-I | 1.0 |

| | |
|---|---|
| ^{a}Mixture of 30 parts Binder I, 10 parts Binder II and 60 parts Solvent. | |

### Example 7

In this example the photoinitiator system was benzophenone and Michler's Ketone, which has maximum sensitivity at 360 nm. The dielectric layer had the composition given in Table 1 with the vehicle mixture given in Table 4 below. The patterning composition used was that in Table 3.

**Table 4**

| **Vehicle Mixture for Example 7** | |
|---|---|
| **Ingredient** | **Parts** |
| Binder I | 40.00 |
| Solvent | 54.90 |
| Stabilizer | 0.30 |
| Benzophenone | 4.00 |
| Michler's Ketone | 0.80 |

**Table 5**

| **Results** | | | | |
|---|---|---|---|---|
| **Example** | **Imaging**^{**a**} **Exposure** | **Smallest Via**^{**b**} | **Fluorescent**^{**c**} **Exposure** | **Dielectric Layer** |
| 1 | 4 | 5 | 36 | No Fog |
| 2 | 4 | 6 | 12 | No Fog |
| 3 | 12 | 5 | 12 | No Fog |
| 4 | 8 | 5 | 12 | No Fog |
| 5 | 8 | 5 | 36 | No Fog |
| 6 | 8 | 5 | 36 | No Fog |
| 7 | 4 | 5 | 36 | Polymerized |

| | | | | |
|---|---|---|---|---|
| ^{**a**}exposure to mercury xenon lamp, in seconds | | | | |
| ^{**b**}mils (0.0025 cm) | | | | |
| ^{**c**}exposure to fluorescent light, in hours | | | | |

The results show the excellent resolution of all the dielectric layers prepared according to the process of the invention. In addition, it can be seen that using the initiators of Examples 1-6 results in a photohardenable layer with excellent white light stability. It should be noted, however, that the invention can be practiced with good results using the composition of Example 7, so long as the adequate precautions are taken to avoid exposure of the photohardenable material to room light during processing, i.e., yellow light conditions are maintained.

### Examples 8-10

These examples illustrate the process of the invention using different photohardenable dielectric materials, and imaging for different time periods.

### Example 8

The photosensitive dielectric layer had the composition shown in Table 6 below.

**Table 6**

| **Photohardenable Dielectric Composition** | |
|---|---|
| **Ingredient** | **Parts** |
| Frit III | 30.50 |
| Alumina II | 19.50 |
| Cobalt Aluminate | 1.10 |
| Quartz | 3.90 |
| Vehicle Mixture | 31.00 |
| Monomer I | 8.48 |
| Monomer II | 2.12 |
| AB-I | 2.10 |
| Solvent II | 3.00 |

The vehicle mixture and patterning layer composition were the same as in Example 7.

The photohardenable dielectric layer was applied as described above to a wet thickness of 40-50 micrometers. The patterning layer was applied as described above and different samples of the assembly were exposed for 1.0, 1.5, and 2.0 seconds. Development and firing as described above resulted in open vias of 3, 4 and 5 mils (0.0075, 0.010 and 0.0125 cm) in diameter. This represents excellent resolution.

### Example 9

The photosensitive dielectric layer had the composition shown in Table 7 below.

**Table 7**

| **Photohardenable Dielectric Composition** | |
|---|---|
| **Ingredient** | **Parts** |
| Frit II | 27.40 |
| Alumina I | 27.60 |
| Vehicle Mixture | 31.00 |
| Monomer I | 8.48 |
| Monomer II | 2.12 |
| AB-I | 2.10 |
| Solvent | 1.30 |

The vehicle mixture and patterning layer composition were the same as in Example 7.

The photohardenable dielectric layer was applied as described above to a wet thickness of 40-50 micrometers. The patterning layer was applied as described above and different samples of the assembly were exposed for 1.0, 1.5, and 2.0 seconds. Development and firing, as described above, resulted in open vias of 3, 4 and 5 mils (0.0075, 0.010 and 0.0125 cm) in diameter. This represents excellent resolution.

### Example 10

The photohardenable dielectric layer had the composition shown in Table 8 below.

**Table 8**

| **Photohardenable Dielectric Composition** | |
|---|---|
| **Ingredient** | **Parts** |
| Frit II | 28.60 |
| Alumina I | 21.90 |
| Quartz | 4.50 |
| Vehicle Mixture | 31.00 |
| Monomer I | 8.48 |
| Monomer II | 2.12 |
| AB-I | 2.10 |
| Solvent | 1.30 |

The vehicle mixture and patterning layer composition were the same as in Example 7.

The photohardenable dielectric layer was applied as described above to a wet thickness of 40-50 micrometers. The patterning layer was applied as described above and different samples of the assembly were exposed for 1.0, 1.5, and 2.0 seconds. Development and firing as described above resulted in open vias of 3, 4 and 5 mils (0.0075, 0.010 and 0.0125 cm) in diameter. This is excellent resolution.

## Claims

1. A method for forming a dielectric layer in a pattern, comprising the steps:
(a) applying to a substrate an unpatterned photohardenable first layer comprising (1) finely divided particles of non-glassy dielectric solids and (2) finely divided particles of an inorganic binder having a softening point temperature in the range from 550 to 825C dispersed in a matrix of (3) an organic polymeric binder, (4) a photoinitiating system, (5) a monomer and (6) an organic solvent;
(b) applying to the photohardenable first layer a second patterning layer comprising an agent which prevents the transmission of actinic radiation;
(c) exposing the photohardenable first layer to actinic radiation to effect photohardening of the photohardenable first layer in those areas not covered by the second patterning layer;
(d) removing the second patterning layer and the underlying non-photohardened areas of the first layer; and
(e) heating the substrate and the remaining photohardened areas of the first layer from step (d) to a temperature sufficient to effect volatilization of the organic binder, the photoinitiating system, the monomer and the organic solvent, and to effect sintering of the dielectric solids and inorganic binder.

2. The method of claim 1 wherein the dielectric solids are selected from the group consisting of alumina, aluminates, titanates, zirconates, stannates, and mixtures thereof.

3. The method of claim 1 wherein the organic polymeric binder is selected from the group consisting of homopolymers and copolymers of alkyl acrylates, alkyl methacrylates, styrene, substituted styrenes, mono-olefins, alkylene oxide, and mixtures thereof.

4. The method of claim 1 wherein the agent which prevents the transmission of actinic radiation is a pigment.

5. The method of claim 4 wherein the pigment is carbon black.

6. The method of claim 1 wherein the second patterning layer further comprises inorganic solids.

7. The method of claim 6 wherein the inorganic solids are alumina.

8. The method of claim 1 wherein the unpatterned photohardenable first layer and the second patterning layer are both applied by screen printing.

9. The method of claim 1 wherein the photoinitiating system is sensitive to actinic radiation having a wavelength less than 350 nm and the photohardenable first layer is white light stable.
